# EUROPEAN PATENT SPECIFICATION

(11) **EP 2 858 467 B1**
(45) Date of publication and mention of the grant of the patent: **05.01.2022**
(21) Application number: 14180165.4
(22) Date of filing: 07.08.2014
(51) Int. Cl.: H05K 1/18

(54) **Locating optical structures to LEDs**
Lokalisierung optischer Strukturen an LEDs
Localisation des structures optiques à DEL

(30) Priority: 30.09.2013 US 201314041874
(43) Date of publication of application: 08.04.2015
(73) Proprietor: Goodrich Corporation, Charlotte, NC 28217-4578 (US)
(72) Inventor: Biehle, Gerald B., Phoenix, AZ Arizona 85022-3771 (US)
(74) Representative: Dehns

(56) References cited:
- EP-A1- 2 019 256
- WO-A1-2013/117657
- US-A- 5 130 761
- US-A1- 2006 045 530
- US-A1- 2013 032 703
- None

## Description

### BACKGROUND

Various mechanical parts, such as airplane parts, employ light sources that are integrated into a printed wiring board. The printed wiring board is then generally secured to the mechanical part or other machined part which may include optical structures for directing the light from the light sources of the printed wiring board. The optical structures often need to be placed close to these light sources with high positional precision. For example a reflector located on the mechanical part may need to be located very precisely relative to the light source. Such precision is difficult to obtain when the light source and optical structures are on separate parts.

EP2019256 describes a lighting module for vehicle headlights in which the light emitting diodes, used as a source of light are mounted on a printed circuit board forming a support structure for them, and on which support structure there are also installed the optical elements focussing and reflecting the beams of light from the sources to direct them in a desired direction.

### SUMMARY

The present invention is defined the method of claim 1 and the optical device of claim 8.

### BRIEF DESCRIPTION OF THE SEVERAL VIEWS OF THE DRAWINGS

The subject matter which is regarded as the invention is particularly pointed out and distinctly claimed in the claims at the conclusion of the specification. The forgoing and other features, and advantages of the invention are apparent from the following detailed description by way of example only and taken in conjunction with the accompanying drawings in which:
Figure 1 shows an illustrative example of an optical device not forming a part of the invention and provided only for better understanding of the invention;
Figure 2 shows an optical device that is formed using the method of the invention.
Figure 3 shows a cross-section of a slot and a hole formed in a part attached to the optical device of Figure 2; and
Figure 4 shows a flowchart of an illustrative method of the present invention.

### DETAILED DESCRIPTION

Various printed wiring boards, i.e., circuit boards, include light sources, such as light emitting diodes (e.g., LEDs) that provide a light when activated. Optical structures such as lenses, reflective surfaces, etc., are generally secured at selected locations with respect to the light sources in order to reflect or divert the light or perform other optical functions. The present invention places such optical structures on the same printed wiring board as the light sources and close to the light sources. When these optical structures and their related light sources are at such close distances, spatial tolerances of 1/1000 of an inch (0.00254 cm) are generally demanded. Such tolerances are difficult to obtain using known methods. However, these tolerances are routinely achieved in the manufacture of printed wiring boards and the electrical components that are formed during such manufacture, such as semiconductors, transistors, circuit wires, etc. Exemplary manufacturing techniques may include lithography, photoetching, plating techniques, etc. Therefore, using these manufacturing techniques, the present invention forms structures on the printed wiring board that may be used to place optical structures and light sources at separation distances that are within a selected tolerance.

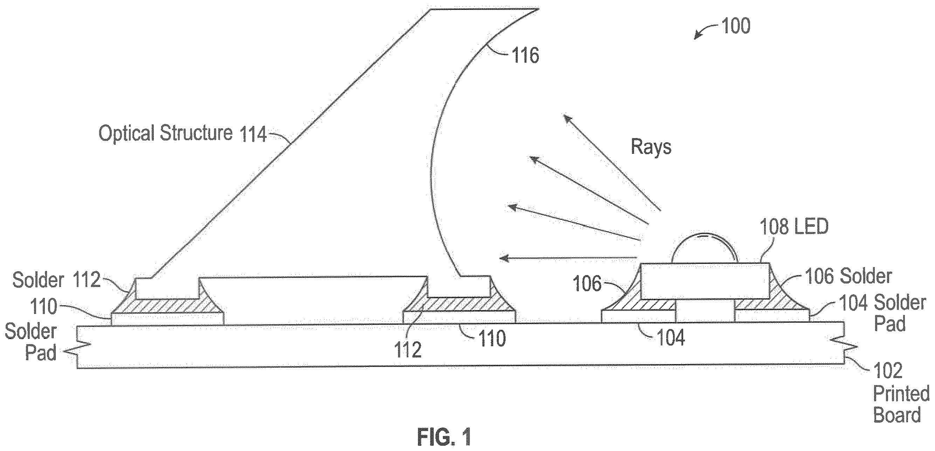

Figure 1 shows an illustrative example, not forming a part of the invention, of an optical device 100 .

The optical device 100 includes a printed wiring board 102 that includes solder pads 104 and 110 that may be formed thereon using manufacturing techniques such as lithography, photoetching, plating techniques, etc. In an exemplary embodiment, material for the solder pad may be deposited on the printed wiring board 102, and a mask may then be applied to the material. The mask may include a design for determining the locations of the solder pads 104 and 110. The design may be transferred to the solder pad material using for instance photoetching techniques and the solder pads 104 and 110 may thus be formed. The locations of the solder pads 104 and 110 on the printed wiring board 102 may therefore be controlled to within a selected tolerance. In an exemplary embodiment, this tolerance is within 1/1000 of an inch (0.00254 cm).

Light source (e.g., LED) 108 is coupled to the solder pads 104. In one embodiment, a selected amount or selected volume of solder 106 is chosen for soldering the light source 108 to the solder pads 104. Similarly, optical structure 114 is coupled to solder pad 110 using a selected volume of solder 112. Surface tension of the solder 106, 112 while heated to a liquid state allows for self-centering of the optical structure 114 and the light source 108, thereby increasing a relative positional precision of the optical structure 114 and the light source 108 once the solder has cooled. The illustrative optical structure 114 includes a reflective surface 116 that is shaped so as to reflect the light from the light source 108 according to a manufacturer's specification. Because the printed wiring board manufacturing techniques (such as those used to form circuit elements, semiconductors, transistors, circuit wires, etc.) are used to form the solder pads 104 and 110, the distances between light source 108 and optical structure 114 may be controlled within a tolerance attainable using such techniques, which is a more rigorous tolerance than is generally required for the particular optical set-up. Thus, the light from the light source 108 may be reflected by the optical structure 114 to meet manufacturing specifications. Additionally, the relative closeness of the optical structure 114 to the light source 108 allows reduced size, mass and moment of inertia of the optical structures 114 as compared to an optical structure that is away from the light source and/or off the printed wiring board.

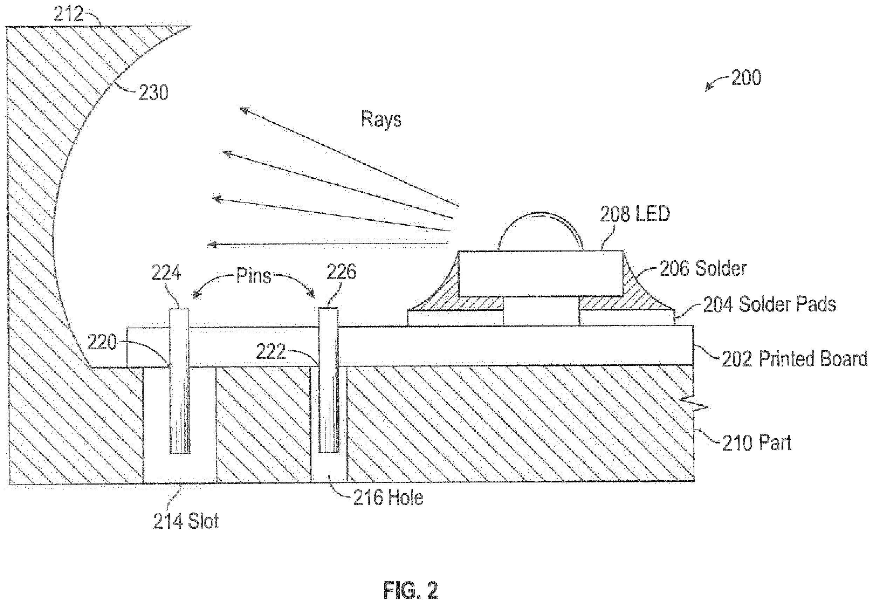

Figure 2 shows an embodiment of the invention presenting an optical device 200 that formed in accordance with the invention.

For larger optical structures for which solder is an insufficient mechanical attachment technique, pins may be located in the printed wiring board 202. Mating holes and slots for these pins may be located in a separate optical structure. Alignment of the pins with the mating holes may position he optical structure relative to the light source to within an acceptable tolerance.

In Figure 2, printed wiring board 202 is coupled to or mechanically attached to part 210 that includes an optical structure 212 formed thereon, The illustrative optical structure 212 includes a reflective surface 230 that is placed at a selected distance with respect to light source 208 once the printed wiring board 202 is coupled to the part 210.

The printed wiring board 202 includes solder pads 204 formed thereon using any of the printed wiring board manufacturing techniques disclosed herein. The printed wiring board 202 also includes holes 220 and 222 formed using these same manufacturing techniques. The light source 208 is soldered to the solder pads 204 using a selected amount of solder 206 using the techniques described above for self-centering. Holes 220 and 222 of the printed wiring board 202 are aligned with slot 214 and hole 216, respectively, of part 210. Pin 224 is inserted into hole 220 and slot 214. Pin 226 is inserted into hole 222 and hole 216. The pins 224 and 226 may thus secure the printed wiring board 202 to the part 210. The pins 224 and 226 may be pins, screws, nails, rivets or any other suitable device for securing the printed wiring board 202 and part 210. Once the part 210 is secured to the printed wiring board 202, the surface 230 of optical structure 212 is positioned at a suitable distance with respect to light source 208, where the distance is within a tolerance suitable for the optical structure to reflect or otherwise direct light from the source according to specifications.

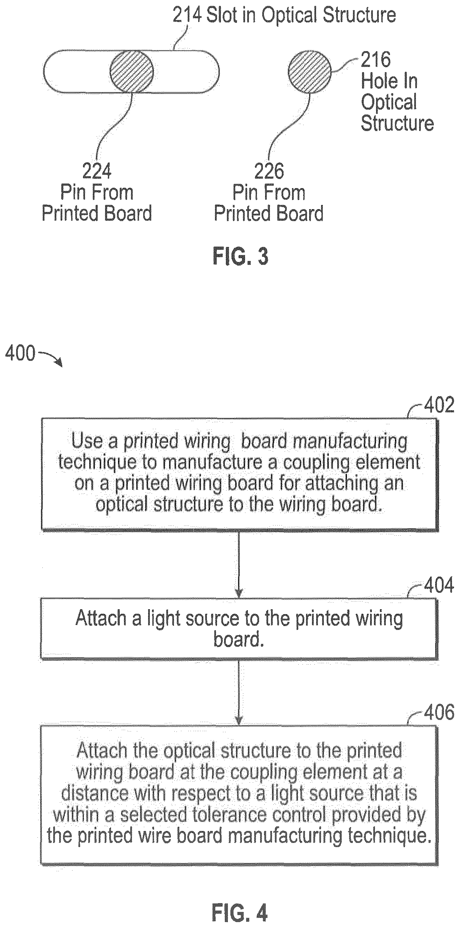

Figure 3 shows a cross-section of the slot 214 and the hole 216 formed in part 210. Slot 214 is shown to include pin 224 and may allow for play or alignment of hole 220 of the printed wiring board 202 with respect to the part 210 prior to fastening the printed wiring board 202 to the part 210. Hole 216 may be of a same circumferential contour as the pin, thereby allowing a snug fit between the pin 226 and the hole 216.

Figure 4 shows a flowchart 400 of a method of the present invention for making the optical device using the methods disclosed herein. In block 402, a technique for manufacturing a printed wiring board and its circuit elements are used to form coupling elements on the printed wiring board for securing an optical structure to the printed wiring board. The coupling element may include solder pads and/or holes. In block 404, a light source is secured to the printed wiring board. In block 406, the coupling element is used to secure an optical structure to the printed wiring board at a distance with respect to the light source that is within a selected tolerance due to the use of the selected manufacturing technique used in forming the coupling element.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one more other features, integers, steps, operations, element components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope of the invention as defined in the appended claims. The embodiment was chosen and described in order to best explain the principles of the invention and the practical application, and to enable others of ordinary skill in the art to understand the invention for various embodiments with various modifications as are suited to the particular use contemplated

While the preferred embodiment to the invention had been described, it will be understood that those skilled in the art, both now and in the future, may make various improvements and enhancements which fall within the scope of the claims which follow. These claims should be construed to maintain the proper protection for the invention first described.

## Claims

1. A method of making an optical device (200), comprising:
forming elements (204) and a first and second hole (220, 222) at selected locations on a printed wiring board (202) using a printed wiring board manufacturing technique to control a tolerance for the locations of the elements (204) and the first and second hole (220, 222);
securing a light source (208) to the printed wiring board at the elements (204);
securing the printed wiring board (202) to a part (210) that includes an optical structure (212) formed thereon using the first and second hole (220, 222) of the printed wiring board (202) and a hole (216) and a slot (214) in the part (210) by inserting a first pin (224) into the first hole (220) and the slot (214), and inserting a second pin (226) into the second hole (222) and the hole (216); and
moving the printed wiring board (202) with respect to the part (210) to adjust a distance between light source (208) and the optical structure (212).

2. The method of claim 1, wherein a selected element (204) further comprises a solder pad and wherein securing the light source (208) to the printed wiring board (202) further comprises soldering the light source (208) to the printed wiring board (202) Z at the solder pad.

3. The method of claim 2 further comprising applying a selected volume of solder between the light source 2 08) and the solder pad to provide self-centering of the one of the light source (208) during a soldering process.

4. The method of claim 1, wherein securing the printed wiring board (202) to the part (210) including aligning the holes (220, 222) of the printed wiring board (202) with the hole (216) and the slot (214) in the part (210) and inserting pins (224, 226).

5. The method of any preceding claim, wherein the printed wiring board manufacturing technique further comprises at least one of: a lithographic technique; a photoetching technique; a plating technique; and a technique used in semiconductor fabrication.

6. The method of any preceding claim wherein the light source (208) is a light emitting diode.

7. The method of any preceding claim, wherein the optical structure (212) is at least one: of a reflective surface; a light shield; and a lens.

8. An optical device, comprising:
a printed wiring board (202) having elements (204) and a first and second hole (220, 222) formed;
a light source (208) secured to the printed wiring board at the elements (204); and
a part (210) including an optical structure (212) formed thereon, the part (210) secured to the printed wiring board (202) using a first pin (224) inserted into the first hole (220) of the printed wiring board (202) and a slot (214) of the part (210), wherein a distance between light source (208) and the optical structure (212) is selectable by moving the first hole (220) with respect to slot (214).

9. The optical device of claim 8, wherein the elements (204) comprise a solder pad.

10. The optical device of claim 9 further comprising a solder between the solder pad and the light source (208), wherein a volume of the solder is selected to provide self-centering of the one of the light source (208) during the soldering process.

11. The optical device of claim 8, further comprising a second pin (226) Z placed through a second hole (222) of the printed wiring board (202) and inserted into a hole (216) in the part (210).

12. The optical device of any of claims 8-1 1 wherein the light source (208) is a light emitting diode.

13. The optical device of any of claims 8-1 2 , wherein the optical structure (212) is at least one: of a reflective surface; and light shield; and a lens.

## Patentansprüche

1. Verfahren zum Herstellen einer optischen Vorrichtung (200), umfassend:
Bilden von Elementen (204) und einem ersten und zweiten Loch (220, 222) an ausgewählten Orten auf einer gedruckten Verdrahtungsplatine (202) unter Verwendung einer Fertigungstechnik für gedruckte Verdrahtungsplatinen, um eine Toleranz für die Orte der Elemente (204) und das erste und zweite Loch (220, 222) zu steuern;
Befestigen einer Lichtquelle (208) an der gedruckten Verdrahtungsplatine an den Elementen (204);
Befestigen der gedruckten Verdrahtungsplatine (202) an einem Teil (210), welches eine optische Struktur (212) beinhaltet, welche darauf unter Verwendung des ersten und zweiten Lochs (220, 222) der gedruckten Verdrahtungsplatine (202) und eines Lochs (216) und eines Schlitzes (214) in dem Teil (210) durch Einfügen eines ersten Stifts (224) in das erste Loch (220) und den Schlitz (214) und Einfügen eines zweiten Stifts (226) in das zweite Loch (222) und das Loch (216) gebildet ist; und
Bewegen der gedruckten Verdrahtungsplatine (202) bezogen auf das Teil (210), um einen Abstand zwischen Lichtquelle (208) und der optischen Struktur (212) anzupassen.

2. Verfahren nach Anspruch 1, wobei ein ausgewähltes Element (204) ferner ein Lötpad umfasst und wobei ein Befestigen der Lichtquelle (208) an der gedruckten Verdrahtungsplatine (202) ferner ein Löten der Lichtquelle (208) an der gedruckten Verdrahtungsplatine (202) an dem Lötpad umfasst.

3. Verfahren nach Anspruch 2, ferner umfassend ein Anwenden eines ausgewählten Volumens von Lötmittel zwischen der Lichtquelle (208) und dem Lötpad, um ein Selbstzentrieren der einen der Lichtquelle (208) während eines Lötprozesses bereitzustellen.

4. Verfahren nach Anspruch 1, wobei ein Befestigen der gedruckten Verdrahtungsplatine (202) an dem Teil (210) ein Ausrichten der Löcher (220, 222) der gedruckten Verdrahtungsplatine (202) an dem Loch (216) und dem Schlitz (214) in dem Teil (210) und ein Einfügen von Stiften (224, 226) beinhaltet.

5. Verfahren nach einem der vorstehenden Ansprüche, wobei die Fertigungstechnik für die gedruckte Verdrahtungsplatine mindestens eines von Folgendem umfasst: eine Lithografietechnik; eine Fotoätztechnik; eine Plattierungstechnik und eine Technik, welche bei der Halbleiterherstellung verwendet wird.

6. Verfahren nach einem der vorstehenden Ansprüche, wobei die Lichtquelle (208) eine lichtemittierende Diode ist.

7. Verfahren nach einem der vorstehenden Ansprüche, wobei die optische Struktur (212) mindestens eines von Folgendem ist:
eine reflektierende Fläche; ein Lichtschutzschirm und eine Linse.

8. Optische Vorrichtung, umfassend:
eine gedruckte Verdrahtungsplatine (202), welche Elemente (204) und ein erstes und zweites gebildetes Loch (220, 222) aufweist;
eine Lichtquelle (208), welche an der gedruckten Verdrahtungsplatine an den Elementen (204) befestigt ist; und
ein Teil (210), welches eine optische Struktur (212) beinhaltet, welche darauf gebildet ist, wobei das Teil (210), an der gedruckten Verdrahtungsplatine (202) unter Verwendung eines ersten Stifts (224) befestigt ist, welcher in das erste Loch (220) der gedruckten Verdrahtungsplatine (202) und einen Schlitz (214) des Teils (210) eingefügt ist, wobei ein Abstand zwischen Lichtquelle (208) und der optischen Struktur (212) auswählbar ist durch ein Bewegen des ersten Lochs (220) bezogen auf den Schlitz (214).

9. Optische Vorrichtung nach Anspruch 8, wobei die Elemente (204) ein Lötpad umfassen.

10. Optische Vorrichtung nach Anspruch 9, ferner umfassend ein Lötmittel zwischen dem Lötpad und der Lichtquelle (208), wobei ein Volumen des Lötmittels ausgewählt ist, um ein Selbstzentrieren der einen der Lichtquelle (208) während des Lötprozesses bereitzustellen.

11. Optische Vorrichtung nach Anspruch 8, ferner umfassend einen zweiten Stift (226), welcher durch ein zweites Loch (222) der gedruckten Verdrahtungsplatine (202) platziert ist und in ein Loch (216) in dem Teil (210) eingefügt ist.

12. Optische Vorrichtung nach einem der Ansprüche 8-11, wobei die Lichtquelle (208) eine lichtemittierende Diode ist.

13. Optische Vorrichtung nach einem der Ansprüche 8-12, wobei die optische Struktur (212) mindestens eines von Folgendem ist: eine reflektierende Fläche; ein Lichtschutzschirm und eine Linse.

## Revendications

1. Procédé de fabrication d'un dispositif optique (200), comprenant :
la formation d'éléments (204) et d'un premier et d'un second trou (220, 222) à des emplacements sélectionnés sur une carte de circuit imprimé (202) à l'aide d'une technique de fabrication de carte de circuit imprimé pour contrôler une tolérance pour les emplacements des éléments (204) et du premier et du second trou (220, 222) ;
la fixation d'une source de lumière (208) sur la carte de circuit imprimé au niveau des éléments (204) ;
la fixation de la carte de circuit imprimé (202) sur une partie (210) qui comporte une structure optique (212) formée sur celle-ci à l'aide du premier et du second trou (220, 222) de la carte de circuit imprimé (202) et d'un trou (216) et d'une fente (214) dans la partie (210) par l'insertion d'une première goupille (224) dans le premier trou (220) et la fente (214), et l'insertion d'une seconde goupille (226) dans le second trou (222) et le trou (216) ; et
le déplacement de la carte de circuit imprimé (202) par rapport à la partie (210) pour ajuster une distance entre la source de lumière (208) et la structure optique (212).

2. Procédé selon la revendication 1, dans lequel un élément sélectionné (204) comprend en outre un plot de soudure et dans lequel la fixation de la source de lumière (208) sur la carte de circuit imprimé (202) comprend en outre le soudage de la source de lumière (208) sur la carte de circuit imprimé (202) au niveau du plot de soudure.

3. Procédé selon la revendication 2 comprenant en outre l'application d'un volume sélectionné de soudure entre la source de lumière (208) et le plot de soudure pour conférer un auto-centrage de l'une de la source de lumière (208) pendant un processus de soudage.

4. Procédé selon la revendication 1, dans lequel la fixation de la carte de circuit imprimé (202) sur la partie (210) comporte l'alignement des trous (220, 222) de la carte de circuit imprimé (202) avec le trou (216) et la fente (214) dans la partie (210) et l'insertion de goupilles (224, 226).

5. Procédé selon une quelconque revendication précédente, dans lequel la technique de fabrication de carte de circuit imprimé comprend en outre au moins l'une parmi : une technique lithographique ; une technique de photogravure ; une technique de placage ; et une technique utilisée dans la fabrication de semi-conducteurs.

6. Procédé selon une quelconque revendication précédente dans lequel la source de lumière (208) est une diode électroluminescente.

7. Procédé selon une quelconque revendication précédente, dans lequel la structure optique (212) est au moins l'une parmi :
une surface réfléchissante ; un pare-lumière ; et une lentille.

8. Dispositif optique, comprenant :
une carte de circuit imprimé (202) ayant des éléments (204) et un premier et un second trou (220, 222) formés ;
une source de lumière (208) fixée sur la carte de circuit imprimé au niveau des éléments (204) ; et
une partie (210) comportant une structure optique (212) formée sur celle-ci, la partie (210) étant fixée à la carte de circuit imprimé (202) à l'aide d'une première goupille (224) insérée dans le premier trou (220) de la carte de circuit imprimé (202) et une fente (214) de la partie (210), dans lequel une distance entre la source de lumière (208) et la structure optique (212) est apte à être sélectionnée par le déplacement du premier trou (220) par rapport à la fente (214).

9. Dispositif optique selon la revendication 8, dans lequel les éléments (204) comprennent un plot de soudure.

10. Dispositif optique selon la revendication 9 comprenant en outre une soudure entre le plot de soudure et la source de lumière (208), dans lequel un volume de la soudure est sélectionné pour conférer un auto-centrage de l'une de la source de lumière (208) pendant le processus de soudage.

11. Dispositif optique selon la revendication 8, comprenant en outre une seconde goupille (226) placée à travers un second trou (222) de la carte de circuit imprimé (202) et insérée dans un trou (216) dans la partie (210).

12. Dispositif optique selon l'une quelconque des revendications 8 à 11 dans lequel la source de lumière (208) est une diode électroluminescente.

13. Dispositif optique selon l'une quelconque des revendications 8 à 12, dans lequel la structure optique (212) est au moins l'une parmi : une surface réfléchissante ; et un pare-lumière ; et une lentille.
